# EUROPEAN PATENT SPECIFICATION

(11) **EP 4 187 598 B1**
(45) Date of publication and mention of the grant of the patent: **29.05.2024**
(21) Application number: 22209067.2
(22) Date of filing: 23.11.2022
(51) Int. Cl.: H01L 25/075, H01L 33/00, H01L 33/50

(54) **PROCESSING METHOD OF LED DISPLAY MODULE**
VERARBEITUNGSVERFAHREN FÜR EIN LED-ANZEIGEMODUL
PROCÉDÉ DE TRAITEMENT DE MODULE D'AFFICHAGE À DEL

(30) Priority: 24.11.2021 CN 202111408847
(43) Date of publication of application: 31.05.2023
(73) Proprietor: Leyard Optoelectronic Co., Ltd., Beijing 100091 (CN)
(72) Inventor: LU, Changjun, Beijing 100091 (CN); MA, Li, Beijing 100091 (CN)
(74) Representative: Berggren Oy

(56) References cited:
- EP-B1- 3 192 846
- CN-B- 109 979 960

## Description

### Cross-Reference to Related Application

The present invention claims the priority to Chinese Patent Application No. 202111408847.X, filed to the Chinese Patent Office on November 24, 2021 and entitled "Processing Method of LED Display Module".

### Technical Field

The invention relates to a field of Light Emitting Diode (LED) display, in particular to a processing method of an LED display module.

### Background

A quantum dot is a three-dimensional semiconductor nanostructure, which can be electro-induced or photo-induced to emit light. A color of emitted light is related to a size of the quantum dot. The quantum dot is non-water-resistant, non-oxygen-resistant and non-temperature-resistant, and is mainly prepared into a quantum dot film in a related art, which is used as a color conversion film. In LED direct display, an LED is arranged in front of a screen as a direct display unit.

China patent application with a publication number of CN109979960A discloses a quantum dot LED display technology. Grooves are etched on a substrate, and quantum dots are filled into the grooves to form a quantum dot substrate. Then the quantum dot substrate and a display substrate are butted to prepare the quantum dot LED display module.

By adopting the above method, a requirement of a precision of butt joint between the quantum dot substrate and the display substrate is high. When a position of an LED chip is offset, the quantum dot substrate and the display substrate are difficult to butt, and it is difficult to prepare the quantum dot LED display module.

EP 3 192 846 B1 relates to a processing method of an LED display module.

### Summary

The invention aims to provide a processing method of an LED display module, so as to solve a problem that a quantum dot LED display module is difficult to prepare in a related art.

In order to achieve the above purpose, the invention provides a processing method of an LED display module. The processing method of the LED display module includes following steps: acquiring a first LED chip emitting blue light and a second LED chip emitting blue light, a wavelength of the first LED chip being smaller than a wavelength of the second LED chip; placing the first LED chip on a first temporary substrate with a front surface of the first LED chip facing upward, and placing the second LED chip on a second temporary substrate with a front surface of second LED chip facing upward; packaging a bottom and a side of the first LED chip with a first reflective adhesive, and packaging a bottom and a side of the second LED chip with a second reflective adhesive; packaging the front surface of the first LED chip with a first isolation layer, and packaging the front surface of the second LED chip with a second isolation layer; removing the first temporary substrate to obtain a first package containing the first LED chip, and removing the second temporary substrate to obtain a second package containing the second LED chip, a height of the second package being greater than a height of the first package; fixing a plurality of display units to a substrate, each of the plurality of display units including two first packages and one second package; spraying a red quantum layer on a front surface of one of the two first packages to obtain a red quantum package; spraying a green quantum layer on a front surface of the other one of the two first packages to obtain a green quantum package; and a front surface of the red quantum package, a front surface of the green quantum package and a front face of the second package being flush.

In some embodiments, after a step of fixing the plurality of display units to the substrate, each of the plurality of display units including two first packages and one second package; spraying the red quantum layer on the front surface of one of the two first packages to obtain the red quantum package; spraying the green quantum layer on the front surface of the other one of the two first packages to obtain the green quantum package; and the front surface of the red quantum package, the front surface of the green quantum package and the front face of the second package being flush, the processing method of the LED display module further includes: filling an area outside the red quantum package, the green quantum package and the second package on the substrate with a light-absorbing adhesive layer, a front surface of the light-absorbing adhesive layer being flush with the front surface of the red quantum package, the front surface of the green quantum package and the front surface of the second package.

In some embodiments, after a step of filling the area outside the red quantum package, the green quantum package and the second package on the substrate with the light-absorbing adhesive layer, the front surface of the light-absorbing adhesive layer being flush with the front surface of the red quantum package, the front surface of the green quantum package and the front surface of the second package, the processing method of the LED display module further includes: packaging a display module containing the light-absorbing adhesive layer with a protective layer, a light transmittance of the protective layer being greater than or equal to 30%.

In some embodiments, before a step of placing the first LED chip on the first temporary substrate with the front surface of the first LED chip facing upward, and placing the second LED chip on the second temporary substrate with the front surface of second LED chip facing upward, the processing method of the LED display module further includes: coating the first temporary substrate with a first release agent or a first release adhesive, and coating the second temporary substrate with a second release agent or a second release adhesive.

In some embodiments, in a step of packaging the bottom and the side of the first LED chip with the first reflective adhesive, and packaging the bottom and the side of the second LED chip with the second reflective adhesive, a thickness of the first reflective adhesive located outside the side of the first LED chip is greater than a first thickness, the first thickness being a sum of a thickness of an epitaxial layer of the first LED chip and a thickness of an electrode of the first LED chip; and a thickness of the second reflective adhesive located outside the side of the second LED chip is greater than a second thickness, the second thickness being a sum of a thickness of an epitaxial layer of the second LED chip and a thickness of an electrode of the second LED chip.

In some embodiments, the thickness of the first reflective adhesive located outside the side of the first LED chip is smaller than a thickness of the first LED chip, a thickness of the first LED chip is equal to a sum of a thickness of a substrate of the first LED chip, the thickness of the epitaxial layer of the first LED chip and the thickness of the electrode of the first LED chip. The thickness of the second reflective adhesive located outside the side of the second LED chip is smaller than a thickness of the second LED chip, the thickness of the second LED chip being equal to a sum of a thickness of the substrate of the second LED chip, the thickness of the epitaxial layer of the second LED chip and the thickness of the electrode of the second LED chip.

In some embodiments, in the step of placing the first LED chip on the first temporary substrate with the front surface of the first LED chip facing upward, and placing the second LED chip on the second temporary substrate with the front surface of second LED chip facing upward, a plurality of first LED chips and a plurality of second LED chips are arranged at intervals. In a step of removing the first temporary substrate to obtain the first package containing the first LED chip, and removing the second temporary substrate to obtain the second package containing the second LED chip, after the first temporary substrate is removed, a plurality of first packages containing the first LED chip are obtained by performing cutting with one first LED chip as a unit, and after the second temporary substrate is removed, a plurality of second packages containing the second LED chip are obtained by performing cutting with one second LED chip as a unit.

In some embodiments, in the step of removing the first temporary substrate to obtain the first package containing the first LED chip, and removing the second temporary substrate to obtain the second package containing the second LED chip, a ratio of a volume of the first package to a volume of the first LED chip ranges from 1.1 to 2, and a ratio of a volume of the second package to a volume of the second LED chip ranges from 1.1 to 2.

In some embodiments, the wavelength of the first LED chip ranges from 440 nm to 460 nm, and the wavelength of the second LED chip ranges from 460 nm to 475 nm.

In some embodiments, in the step of packaging the bottom and the side of the first LED chip with the first reflective adhesive, and packaging the bottom and the side of the second LED chip with the second reflective adhesive, a reflectivity of the first reflective adhesive is between 85% and 100%, and a reflectivity of the second reflective adhesive is between 85% and 100%.

In some embodiments, in a step of packaging the front surface of the first LED chip with the first isolation layer, and packaging the front surface of the second LED chip with the second isolation layer, the first isolation layer includes a first epoxy resin or a first silica gel, and the second isolation layer includes a second epoxy resin or a second silica gel.

By applying a technical solution of the invention, the processing method of the LED display module includes following steps: acquiring the first LED chip emitting blue light and the second LED chip emitting blue light, the wavelength of the first LED chip being smaller than the wavelength of the second LED chip; placing the first LED chip on the first temporary substrate with the front surface of the first LED chip facing upward, thus, the first temporary substrate bears the first LED chip, facilitating packaging the first LED chip; and placing the second LED chip on the second temporary substrate with the front surface of second LED chip facing upward, thus, the second temporary substrate bears the second LED chip, facilitating packaging the second LED chip; packaging the bottom and the side of the first LED chip with the first reflective adhesive, and packaging the bottom and the side of the second LED chip with the second reflective adhesive, the first reflective adhesive reflects a light of the first LED chip, improving a light utilization rate of the first LED chip, and the second reflective adhesive reflects a light of the second LED chip, improving a light utilization rate of the second LED chip; packaging the front surface of the first LED chip with the first isolation layer, and packaging the front surface of the second LED chip with the second isolation layer; removing the first temporary substrate to obtain the first package containing the first LED chip, and removing the second temporary substrate to obtain the second package containing the second LED chip, a height of the second package being greater than a height of the first package; fixing the plurality of display units to the substrate, each of the plurality of display units including two first packages and one second package; spraying the red quantum layer on the front surface of one of the two first packages to obtain the red quantum package; spraying the green quantum layer on the front surface of the other one of the two first packages to obtain the green quantum package; and the front surface of the red quantum package, the front surface of the green quantum package and the front face of the second package being flush. The first isolation layer protects the front surface of the first LED chip and blocks a heat of the first LED chip from being directly conducted to the red quantum layer, which reduces an influence of the heat on the red quantum layer. The second isolation layer protects the front surface of the second LED chip and blocks a heat of the second LED chip from being directly conducted to the green quantum layer, which reduces an influence of the heat on the green quantum layer. Thus, the LED display module obtained by the processing method of the LED display module does not need to adopt the method of butting a quantum dot substrate and a display substrate in the related art, and does not need to consider an offset of position of the LED chip, so that the LED display module is easily processed. Therefore, the technical solution of the application solves the problem that a quantum dot LED display module is difficult to prepare in the related art.

### Brief Description of the Drawings

The drawings consisting of a part of the invention are used for further understanding of the present invention. The schematic embodiments and description thereof are used for explaining the invention and do not limit the invention improperly. In the drawings,
Fig. 1 illustrates a flowchart of an embodiment of a processing method of an LED display module according to the invention.
Fig. 2 illustrates a structural schematic diagram of a first LED chip being placed on a first temporary substrate in the processing method of the LED display module of Fig. 1.
Fig. 3 illustrates a structural schematic diagram of a first reflective adhesive being packaged on the first LED chip in the processing method of the LED display module of Fig. 1.
Fig. 4 illustrates a structural schematic diagram of a second LED chip being placed on a second temporary substrate in the processing method of the LED display module of Fig. 1.
Fig. 5 illustrates a structural schematic diagram of a second reflective adhesive being packaged on the second LED chip in the processing method of the LED display module of Fig. 1.
Fig. 6 illustrates a structural schematic diagram of a first isolation layer being arranged on the first LED chip in the processing method of the LED display module of Fig. 1.
Fig. 7 illustrates a structural schematic diagram of a second isolation layer being arranged on the second LED chip in the processing method of the LED display module of Fig. 1.
Fig. 8 illustrates a structural schematic diagram of a first package in the processing method of the LED display module of Fig. 1.
Fig. 9 illustrates a structural schematic diagram of a second package in the processing method of the LED display module of Fig. 1.
Fig. 10 illustrates a structural schematic diagram of two first packages and one second package being arranged on a substrate in the processing method of the LED display module of Fig. 1.
Fig. 11 is a structural schematic diagram of a red quantum package, a green quantum package and the second package being arranged on the substrate in the processing method of the LED display module of Fig. 1.
Fig. 12 illustrates a structural schematic diagram after the substrate is filled with a light-absorbing adhesive layer in the processing method of the LED display module of Fig. 1.
Fig. 13 illustrates a structural schematic diagram of a protective layer being arranged on the light-absorbing adhesive layer in the processing method of the LED display module of Fig. 1.
Fig. 14 illustrates a structural schematic diagram of the first LED chip in the processing method of the LED display module of Fig. 1.
Fig. 15 illustrates a structural schematic diagram of the second LED chip in the processing method of the LED display module of Fig. 1.

Herein, the above drawings include the following reference numbers:
1. First package; 2. Second package; 11. First LED chip; 12. Second LED chip; 21. First temporary substrate; 22. Second temporary substrate; 23. Substrate; 31. First reflective adhesive; 32. Second reflective adhesive; 41. First isolation layer; 42. Second isolation layer; 51. Red quantum layer; 52. Green quantum layer; 61. Light-absorbing adhesive layer; and 62. Protective layer.

### Detailed Description of the Embodiments

The technical solutions in the embodiments of the invention will be clearly and completely described below in combination with the drawings in the embodiments of the invention. It is apparent that the described embodiments are not all embodiments but part of embodiments of the invention. In fact, the description of at least one exemplary embodiment below is merely illustrative, and will not be taken as any limitation to the invention and its application or use. All other embodiments obtained by those of ordinary skill in the art on the basis of the embodiments in the invention without creative work shall fall within the scope of protection of the invention.

It should be noted that the terms used here are only for describing specific implementation modes, and are not intended to limit the exemplary implementation modes according to the application. As used herein, the singular form is also intended to include the plural form unless the context clearly indicates otherwise. In addition, it should also be understood that when the terms "comprising" and/or "including" are used in this specification, same indicate the presence of features, steps, operations, devices, components and/or combinations thereof.

Unless otherwise specified, relative arrangements of parts and steps, digital expressions and values elaborated in these embodiments will not limit the scope of the invention. Meanwhile, it should be understood, to facilitate the description, that the sizes of all parts shown in the drawings are not drawn according to an actual proportionate relationship. The technologies, the methods and the equipment known by those of ordinary skill in the art may not be elaborated. However, where appropriate, the technologies, the methods and the equipment should be deemed to be part of the authorized specification. In all examples shown and discussed here, any specific values should be merely explained to be exemplary rather than taken as a limitation. Therefore, other examples of the exemplary embodiments may have different values. It should be noted that the similar reference numbers and letters indicate the similar items in the drawings below, so there is no need to further discuss it in subsequent drawings once an item is defined in one drawing.

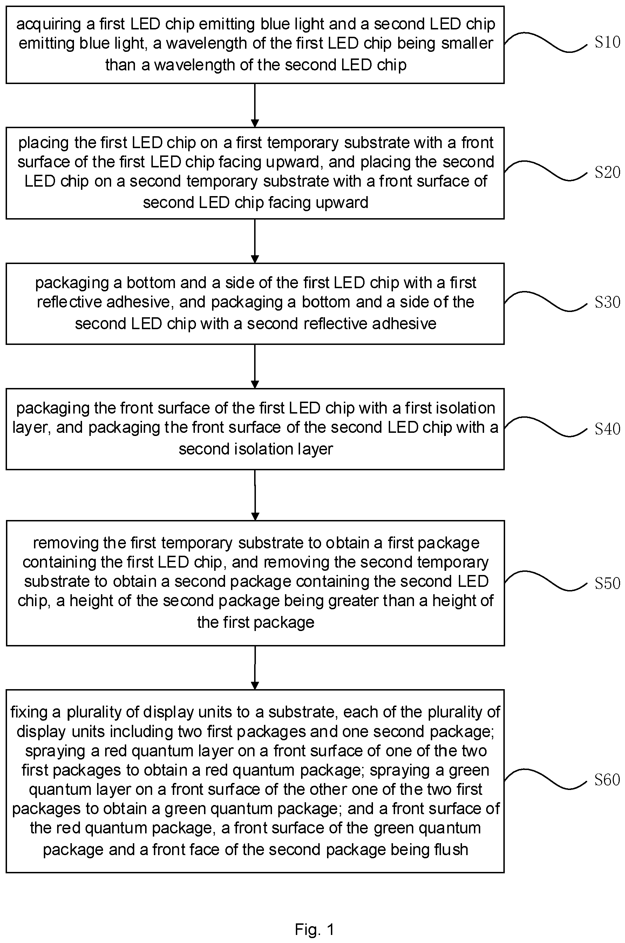

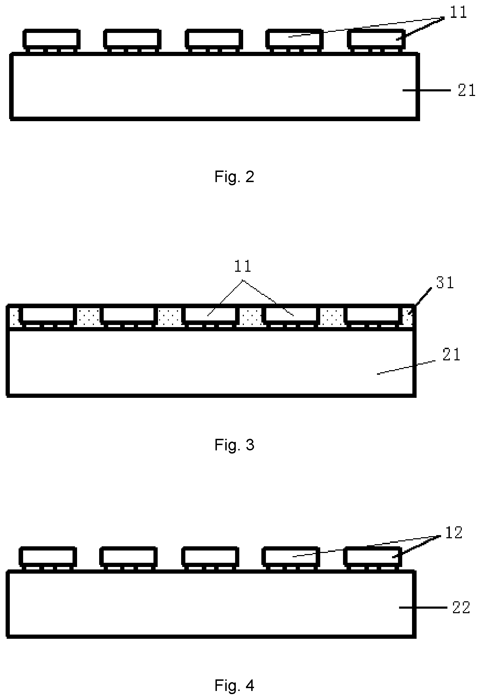

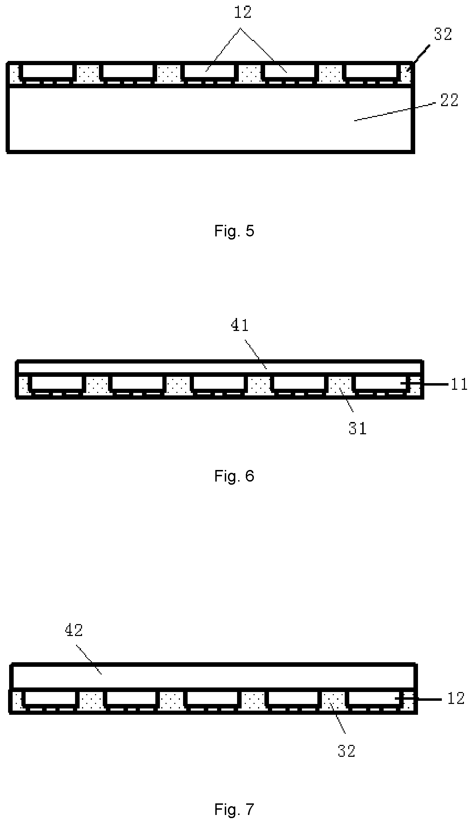

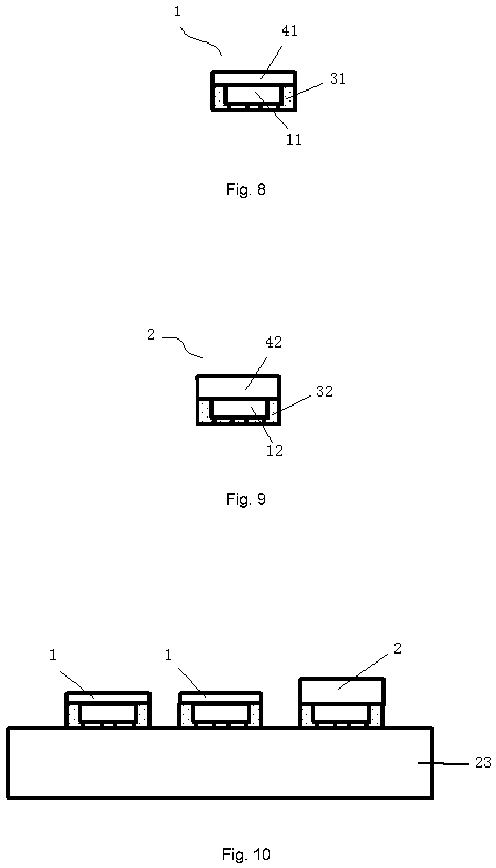

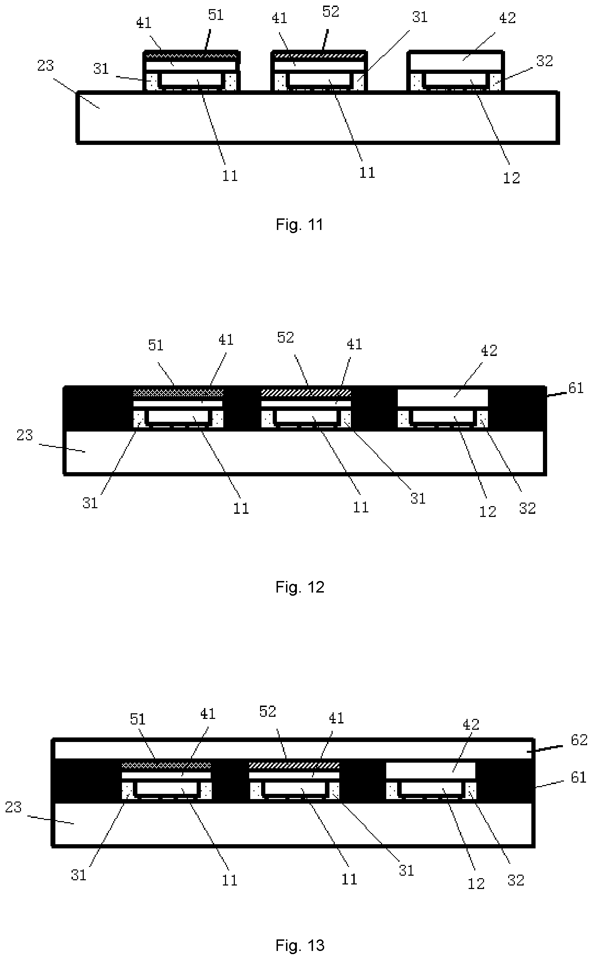

As shown in Figs. 1 to 13, in a processing method of an LED display module of the embodiments, a processing operation is finished in a vacuum chamber. The processing method of the LED display module includes following steps: at S10, acquiring a first LED chip 11 emitting blue light and a second LED chip 12 emitting blue light, a wavelength of the first LED chip 11 being smaller than a wavelength of the second LED chip 12; at S20, placing the first LED chip 11 on a first temporary substrate 21 with a front surface of the first LED chip 11 facing upward, and placing the second LED chip 12 on a second temporary substrate 22 with a front surface of second LED chip 12 facing upward; at S30, packaging a bottom and a side of the first LED chip 11 with a first reflective adhesive 31, and packaging a bottom and a side of the second LED chip 12 with a second reflective adhesive 32; at S40, packaging the front surface of the first LED chip 11 with a first isolation layer 41, and packaging the front surface of the second LED chip 12 with a second isolation layer 42; at S50, removing the first temporary substrate 21 to obtain a first package 1 containing the first LED chip 11, and removing the second temporary substrate 22 obtain a second package 2 containing the second LED chip 12, a height of the second package 2 being greater than a height of the first package 1; and at S60, fixing a plurality of display units to a substrate 23, each of the plurality of display unit including two first packages 1 and one second package 2; spraying a red quantum layer 51 on a front surface of one of the two first packages 1 to obtain a red quantum package; spraying a green quantum layer 52 on a front surface of the other one of the two first packages 1 to obtain a green quantum package; and a front surface of the red quantum package, a front surface of the green quantum package and a front surface of the second package 2 are flush.

By applying the technical solution of the invention, placing the first LED chip 11 on the first temporary substrate 21 with the front surface of the first LED chip 11 facing upward, , thus, the first temporary substrate 21 bears the first LED chip 11, facilitating packaging the first LED chip 11; and placing the second LED chip 12 on the second temporary substrate 22 with the front surface of second LED chip 12 facing upward, thus, the second temporary substrate 22 bears the second LED chip 12, facilitating packaging the second LED chip 12; packaging the bottom and the side of the first LED chip 11 with the first reflective adhesive 31, and packaging the bottom and the side of the second LED chip 12 with the second reflective adhesive 32, the first reflective adhesive 31 reflects a light of the first LED chip 11, improving a light utilization rate of the first LED chip 11, and the second reflective adhesive 32 reflects a light of the second LED chip 12, improving a light utilization rate of the second LED chip 12; packaging the front surface of the first LED chip 11 with the first isolation layer 41, and packaging the front surface of the second LED chip 12 with the second isolation layer 42; removing the first temporary substrate 21 to obtain the first package 1 containing the first LED chip 11, and removing the second temporary substrate 22 obtain the second package 2 containing the second LED chip 12, the height of the second package 2 being greater than the height of the first package 1; fixing the plurality of display units to the substrate 23, each of the plurality of display unit including two first packages 1 and one second package 2; spraying the red quantum layer 51 on the front surface of one of the two first packages 1 to obtain the red quantum package; spraying the green quantum layer 52 on the front surface of the other one of the two first packages 1 to obtain the green quantum package; and the front surface of the red quantum package, the front surface of the green quantum package and the front surface of the second package 2 are flush. Thus, a front surface of each display unit is flat, and a display effect of the display unit is improved. The first isolation layer 41 protects the front surface of the first LED chip 11 and blocks a heat of the first LED chip 11 from being directly conducted to the red quantum layer 51, which reduces an influence of the heat on the red quantum layer 51. The second isolation layer 42 protects the front surface of the second LED chip 12 and blocks a heat of the second LED chip 12 from being directly conducted to the green quantum layer 52, which reduces an influence of the heat on the green quantum layer 52. Thus, the LED display module obtained by the processing method of the LED display module does not need to adopt the method of butting a quantum dot substrate and a display substrate in the related art, and does not need to consider an offset of position of the LED chip, so that the LED display module is easily processed. Therefore, the technical solution of the embodiment solves a problem that the quantum dot LED display module is difficult to prepare in the related art. For convenience of use, both the first temporary substrate 21 and the second temporary substrate 22 withstand a high temperature above 150 °C.

It is to be noted that there are at least two first LED chips 11 emitting blue light and at least one second LED chip 12 emitting blue light in the embodiment. A blue light of the first LED chip 11 is converted by the red quantum layer 51, so that the red quantum package emits red light; the blue light of the first LED chip 11 is converted by the green quantum layer 52, so that the green quantum package emits green light; and the second package 2 emits blue light, so that a cost is lower in comparison with using LED chips emitting ultraviolet light.

As shown in Figs. 1-12, after a step of fixing the plurality of display units to the substrate 23, each of the plurality of display unit including two first packages 1 and one second package 2; spraying the red quantum layer 51 on the front surface of one of the two first packages 1 to obtain the red quantum package; spraying the green quantum layer 52 on the front surface of the other one of the two first packages 1 to obtain the green quantum package; and the front surface of the red quantum package, the front surface of the green quantum package and the front surface of the second package 2 are flush, the processing method of the LED display module further includes: filling an area outside the red quantum package, the green quantum package and the second package 2 on the substrate 23 with a light-absorbing adhesive layer 61, a front surface of the light-absorbing adhesive layer 61 being flush with the front surface of the red quantum package, the front surface of the green quantum package and the front surface of the second package 2. The light-absorbing adhesive layer 61 improves a display contrast of the LED display module. The light-absorbing adhesive layer 61 is preferably ultraviolet curable black glue. The front surface of the light-absorbing adhesive layer 61 is flush with the front surface of the red quantum package, the front surface of the green quantum package and the front surface of the second package 2 to ensure that light emitting surfaces of the plurality of display units are on a same horizontal plane. A display area of each display unit is equal to one pixel.

As shown in Figs. 1-13, after a step of filling the area outside the red quantum package, the green quantum package and the second package 2 on the substrate 23 with the light-absorbing adhesive layer 61, the front surface of the light-absorbing adhesive layer 61 being flush with the front surface of the red quantum package, the front surface of the green quantum package and the front surface of the second package 2, the processing method of the LED display module further includes: packaging a display module containing the light-absorbing adhesive layer 61 with a protective layer 62, a light transmittance of the protective layer 62 being greater than or equal to 30%. The protective layer 62 blocks light from an outside to the red quantum package, the green quantum package and the second package 2 to avoid a reflection on the front surface of the red quantum package, on the front surface of the green quantum package and on the front surface of the second package 2, and blocks a contact of the red quantum layer 51 and the green quantum layer 52 with air, water and oxygen to protect the red quantum package and the green quantum package. The protective layer 62 is made of epoxy resin, silica gel or a film material. A light transmittance of the protective layer 62 is preferably 30% or 40% or 50% or 60% or 70% or 80% or 90% or 100%.

As shown in Figs. 1-13, for a convenience of stripping the first LED chip 11 from the first temporary substrate 21 and for a convenience of stripping the second LED chip 12 from the second temporary substrate 22, before a step of placing the first LED chip 11 on the first temporary substrate 21 with the front surface of the first LED chip 11 facing upward, and placing the second LED chip 12 on the second temporary substrate 22 with the front surface of second LED chip 12 facing upward, the processing method of the LED display module further includes: coating the first temporary substrate 21 with a first release agent or a first release adhesive, and coating the second temporary substrate 22 with a second release agent or a second release adhesive.

As shown in Figs. 1-15, in a step of packaging the bottom and the side of the first LED chip 11 with the first reflective adhesive 31, and packaging the bottom and the side of the second LED chip 12 with the second reflective adhesive 32, a thickness of the first reflective adhesive 31 located outside the side of the first LED chip 11 is greater than a first thickness, and the first thickness is a sum of a thickness of an epitaxial layer of the first LED chip 11 and a thickness of an electrode of the first LED chip 11. Thus, an area around the first LED chip 11 except the front surface of the first LED chip 11 is provided with the first reflective adhesive 31, thus avoiding blue light leakage, and a cost of the first reflective adhesive 31 is reduced at the same time. A thickness of the second reflective adhesive 32 located outside the side of the second LED chip 12 is greater than a second thickness, the second thickness being a sum of a thickness of an epitaxial layer of the second LED chip 12 and a thickness of an electrode of the second LED chip 12. Thus, an area around the second LED chip 12 except the front surface of the second LED chip 12 is provided with the second reflective adhesive 32, thus avoiding blue light leakage, and a cost of the second reflective adhesive 32 is reduced at the same time.

As shown in Figs. 1-15, the thickness of the first reflective adhesive 31 located outside the side of the first LED chip 11 is smaller than a thickness of the first LED chip 11, the thickness of the first LED chip 11 being equal to a sum of the thickness of a substrate of the first LED chip 11, the thickness of the epitaxial layer of the first LED chip 11 and the thickness of the electrode of the first LED chip 11. Thus, the packaged first reflective adhesive 31 mainly covers the bottom and the side of the first LED chip 11, and the front surface of the first LED chip 11 has no or little first reflective adhesive, so that the front surface of the first LED chip 11 is neat. The thickness of the second reflective adhesive 32 located outside the side of the second LED chip 12 is smaller than a thickness of the second LED chip 12, the thickness of the second LED chip 12 being equal to a sum of a thickness of the substrate of the second LED chip 12, the thickness of the epitaxial layer of the second LED chip 12 and the thickness of the electrode of the second LED chip 12. Thus, the packaged second reflective adhesive 32 mainly covers the bottom and the side of the second LED chip 12, and the front surface of the second LED chip 12 has no or little second reflective adhesive, so that the front surface of the second LED chip 12 is neat.

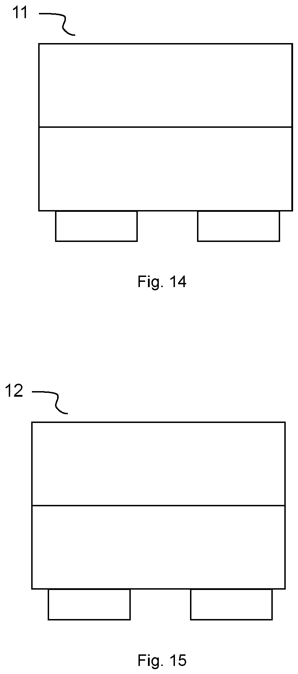

As shown in Fig. 14, the first LED chip 11 includes the substrate (used for supporting the epitaxial layer), the epitaxial layer (used for emitting light), and the electrode arranged in sequence from top to bottom. As shown in Fig. 15, the second LED chip 12 includes the substrate, the epitaxial layer, and the electrode arranged in sequence from top to bottom.

The first reflective adhesive 31 is preferably a first reflective adhesive film, the first reflective adhesive film is used to package the bottom and the side of the first LED chip 11 by mould pressing. Thus, a thickness of the first reflective adhesive film is easy to control, and the first reflective adhesive 31 covers the bottom and the side of the first LED chip 11 more evenly. The second reflective adhesive 32 is preferably a second reflective adhesive film, the second reflective adhesive film is used to package the bottom and the side of the second LED chip 12 by mold pressing. Thus, the second reflective adhesive 32 covers the bottom and the side of the second LED chip 12 more evenly.

As shown in Figs. 1-15, after the step of packaging a bottom and a side of the first LED chip 11 with a first reflective adhesive 31, and packaging a bottom and a side of the second LED chip 12 with a second reflective adhesive 32, the first reflective adhesive 31 remained on the front surface of the first LED chip 11 is removed by plasma bombardment. Thus, the area around the first LED chip 11 except the front surface of the first LED chip 11 is provided with the first reflective adhesive 31, thus avoiding blue light leakage. The second reflective adhesive 32 remained on the front surface of the second LED chip 12 is removed by plasma bombardment. Thus, the area around the second LED chip 12 except the front surface of the second LED chip 12 is disposed with the second reflective adhesive 32, thus avoiding blue light leakage.

As shown in Figs. 1-13, in the step of placing the first LED chip 11 on the first temporary substrate 21 with the front surface of the first LED chip 11 facing upward, and placing the second LED chip 12 on the second temporary substrate 22 with the front surface of second LED chip 12 facing upward, a plurality of first LED chips 11 and a plurality of second LED chips 12 are arranged at intervals. In a step of removing the first temporary substrate 21 to obtain the first package 1 containing the first LED chip 11, and removing the second temporary substrate 22 obtain the second package 2 containing the second LED chip 12, in order to separate the plurality of first LED chips 11 into independent units, after the first temporary substrate 21 is removed, a plurality of first packages 1 containing the first LED chip 11 are obtained by performing cutting with one first LED chip 11 as a unit, and in order to separate the plurality of second LED chips 12 into independent units, after the second temporary substrate 22 is removed, a plurality of second packages 2 containing the second LED chip 12 are obtained by performing cutting with one second LED chip 12 as a unit.

As shown in Figs. 1 to 13, in order to cut a plurality of suitable first packages 1 containing the first LED chip 11 and cut a plurality of suitable second packages 2 containing the second LED chip 12, in the step of removing the first temporary substrate 21 to obtain the first package 1 containing the first LED chip 11, and removing the second temporary substrate 22 obtain the second package 2 containing the second LED chip 12, a ratio of a volume of the first package 1 to a volume of the first LED chip 11 ranges from 1.1 to 2, and a ratio of a volume of the second package 2 to a volume of the second LED chip 12 ranges from 1.1 to 2. Preferably, the ratio of the volume of the first package 1 to the volume of the first LED chip 11 ranges from 1.1 to 1.4, and the ratio of the volume of the second package 2 to the volume of the second LED chip 12 to ranges from 1.1 to 1.4. Specifically, the ratio of the volume of the first package 1 to the volume of the first LED chip 11 is1.1, 1.2, 1.3 or 1.4. Specifically, the ratio of the volume of the second package 2 to the volume of the second LED chip 12 is 1.1, 1.2, 1.3 or 1.4.

As shown in Figs. 1-13, in order to meet a use requirement, the wavelength of the first LED chip 11 ranges from 440 nm to 460 nm, and the wavelength of the second LED chip 12 ranges from 460 nm to 475 nm. Preferably, the wavelength of the first LED chip 11 is 440 nm or 450 nm or 460 nm, and the wavelength of the second LED chip 12 is 460 nm or 470 nm or 475 nm.

As shown in Figs. 1-13, in order to meet processing and use requirements, in the step of packaging the bottom and the side of the first LED chip 11 with the first reflective adhesive 31, and packaging the bottom and the side of the second LED chip 12 with the second reflective adhesive 32, a reflectivity of the first reflective adhesive 31 is between 85% and 100%, and a reflectivity of the second reflective adhesive 32 is between 85% and 100%. Preferably, the reflectivity of the first reflective adhesive 31 is 85% or 90% or 100%, and the reflectivity of the second reflective adhesive 32 is 85% or 90% or 100%.

As shown in Figs. 1-13, in order to better protect the front surface of the first LED chip 11, and at the same time block the heat of the front surface of the first LED chip 11 from being directly conducted to the red quantum layer, so as to avoid affecting a performance of the red quantum layer. Or at the same time block the heat of the front surface of the first LED chip 11 from being directly conducted to the green quantum layer, so as to avoid affecting a performance of the green quantum layer, in a step of packaging the front surface of the first LED chip 11 with the first isolation layer 41, and packaging the front surface of the second LED chip 12 with the second isolation layer 42, the first isolation layer 41 includes a first epoxy resin or a first silica gel, and the second isolation layer 42 includes a second epoxy resin or a second silica gel.

As shown in Figs. 1-13, in order to transfer and fixe the plurality of display units to the substrate 23 at preset display pixel spacing, in the step of fixing the plurality of display units to the substrate 23, each of the plurality of display unit including two first packages 1 and one second package 2; spraying the red quantum layer 51 on the front surface of one of the two first packages 1 to obtain the red quantum package; spraying the green quantum layer 52 on the front surface of the other one of the two first packages 1 to obtain the green quantum package; and the front surface of the red quantum package, the front surface of the green quantum package and the front surface of the second package 2 are flush, each of the plurality of the display units is fixed to the substrate 23 by welding.

The processing method of the LED display module in the embodiment has low requirements for spraying alignment accuracy of the red quantum layer 51 and the green quantum layer 52. For example, even the red quantum layer 51 and the green quantum layer 52 are sprayed to other places outside the first LED chip 11, the red quantum layer 51 (which can be excited by light to emit red light) and the green quantum layer 52 (which can be excited by light to emit green light) sprayed outside the first LED chip 11 can be shielded by the light-absorbing adhesive layer in a subsequent processing. At the same time, a number of thermal processes required by the quantum dot in the process of LED display module processing is reduced, and the thermal process is only required when the protective layer is finally used for packaging. Herein, when the ultraviolet curable black glue is used for packaging, there is no need for thermal process.

The processing method of the LED display module further includes a step of mounting an IC component on a back surface of the substrate 23, and the step of mounting the IC component is performed after a step of processing the front surface of the substrate 23 is completed or before the step of processing the front surface of the substrate 23.

In the description of the invention, it is to be understood that orientation or position relationships indicated by terms "front", "back", "upper", "lower", "left", "right", "transverse", "longitudinal", "vertical", "horizontal", "top", "bottom" and the like are orientation or position relationships shown in the drawings usually, are adopted not to indicate or imply that indicated devices or components must be in specific orientations or structured and operated in specific orientations but only to conveniently describe the invention and simplify descriptions and thus should not be understood as limits to the scope of protection of invention. The orientations "inner" and "outer" are the inside and the outside relative to an outline of each part.

For convenient description, spatially relativity terms such as "on", "above", "on the surface of", "on the top of' may be used herein to describe the spatial positional relationship of one device or one feature to other devices or features as shown in the drawings. It will be understood that the spatially relativity terms are intended to encompass different orientations used or operated in addition to the orientations of the devices described in the drawings. For example, if the device in the drawings is inverted, the device described as "on other devices or configurations" or "above other devices or configurations" will then be positioned "under other devices or configurations" or "below other devices or configurations." Thus, the exemplary term "above" may include both orientations of "above" and "below". The device may also be positioned in other different ways (rotated 90° or at other orientations) and the spatially relativity description used herein is interpreted accordingly.

In addition, it should be noted that terms "first", "second" and the like are used for limiting the parts, for facilitating distinguishing corresponding parts only. Unless otherwise stated, the above terms do not have special meanings, and accordingly should not be understood to limit the scope of protection of the invention.

The above is only the preferred embodiments of the invention and is not used to limit the invention. For those skilled in the art, there may be various changes and variations in the invention which is however defined by the appended claims.

## Claims

1. A processing method of an LED display module, wherein the processing method of the LED display module comprising following steps:
acquiring a first LED chip (11) emitting blue light and a second LED chip (12) emitting blue light, a wavelength of the first LED chip (11) being smaller than a wavelength of the second LED chip (12);
placing the first LED chip (11) on a first temporary substrate (21) with a front surface of the first LED chip (11) facing upward, and placing the second LED chip (12) on a second temporary substrate (22) with a front surface of second LED chip (12) facing upward;
packaging a bottom and a side of the first LED chip (11) with a first reflective adhesive (31), and packaging a bottom and a side of the second LED chip (12) with a second reflective adhesive (32);
packaging the front surface of the first LED chip (11) with a first isolation layer (41), and packaging the front surface of the second LED chip (12) with a second isolation layer (42);
removing the first temporary substrate (21) to obtain a first package (1) containing the first LED chip (11), and removing the second temporary substrate (22) to obtain a second package (2) containing the second LED chip (12), a height of the second package (2) being greater than a height of the first package (1); and
fixing a plurality of display units to a substrate (23), each of the plurality of display units comprising two first packages (1) and one second package (2); spraying a red quantum layer (51) on a front surface of one of the two first packages (1) to obtain a red quantum package; spraying a green quantum layer (52) on a front surface of the other one of the two first packages (1) to obtain a green quantum package; and a front surface of the red quantum package, a front surface of the green quantum package and a front surface of the second package (2) being flush.

2. The processing method of the LED display module as claimed in claim 1, wherein after a step of fixing the plurality of display units to the substrate (23), each of the plurality of display units comprising two first packages (1) and one second package (2); spraying the red quantum layer (51) on the front surface of one of the two first packages (1) to obtain the red quantum package; spraying the green quantum layer (52) on the front surface of the other one of the two first packages (1) to obtain a green quantum package; and the front surface of the red quantum package, the front surface of the green quantum package and the front surface of the second package (2) being flush, the processing method of the LED display module further comprising: filling an area outside the red quantum package, the green quantum package and the second package (2) on the substrate (23) with a light-absorbing adhesive layer (61), a front surface of the light-absorbing adhesive layer (61) being flush with the front surface of the red quantum package, the front surface of the green quantum package and the front surface of the second package (2).

3. The processing method of the LED display module as claimed in claim 2, wherein after a step of filling the area outside the red quantum package, the green quantum package and the second package (2) on the substrate (23) with the light-absorbing adhesive layer (61), the front surface of the light-absorbing adhesive layer (61) being flush with the front surface of the red quantum package, the front surface of the green quantum package and the front surface of the second package (2), the processing method of the LED display module further comprising: packaging a display module containing the light-absorbing adhesive layer (61) with a protective layer (62), a light transmittance of the protective layer (62) being greater than or equal to 30%.

4. The processing method of the LED display module as claimed in claim 1, wherein before a step of placing the first LED chip (11) on the first temporary substrate (21) with the front surface of the first LED chip (11) facing upward, and placing the second LED chip (12) on the second temporary substrate (22) with the front surface of second LED chip (12) facing upward, the processing method of the LED display module further comprising: coating the first temporary substrate (21) with a first release agent or a first release adhesive, and coating the second temporary substrate (22) with a second release agent or a second release adhesive.

5. The processing method of the LED display module as claimed in claim 1, wherein
in a step of packaging the bottom and the side of the first LED chip (11) with the first reflective adhesive (31), and packaging the bottom and the side of the second LED chip (12) with the second reflective adhesive (32):
a thickness of the first reflective adhesive (31) located outside the side of the first LED chip (11) is greater than a first thickness, the first thickness being a sum of a thickness of an epitaxial layer of the first LED chip (11) and a thickness of an electrode of the first LED chip (11),
a thickness of the second reflective adhesive (32) located outside the side of the second LED chip (12) is greater than a second thickness, the second thickness being a sum of a thickness of an epitaxial layer of the second LED chip (12) and a thickness of an electrode of the second LED chip (12).

6. The processing method of the LED display module as claimed in claim 5, wherein
the thickness of the first reflective adhesive (31) located outside the side of the first LED chip (11) is smaller than a thickness of the first LED chip (11), the thickness of the first LED chip (11) being equal to a sum of the thickness of a substrate of the first LED chip (11), the thickness of the epitaxial layer of the first LED chip (11) and the thickness of the electrode of the first LED chip (11),
the thickness of the second reflective adhesive (32) located outside the side of the second LED chip (12) is smaller than a thickness of the second LED chip (12), the thickness of the second LED chip (12) being equal to a sum of a thickness of the substrate of the second LED chip (12), the thickness of the epitaxial layer of the second LED chip (12) and the thickness of the electrode of the second LED chip (12).

7. The processing method of the LED display module as claimed in claim 1, wherein
in a step of placing the first LED chip (11) on the first temporary substrate (21) with the front surface of the first LED chip (11) facing upward, and placing the second LED chip (12) on the second temporary substrate (22) with the front surface of second LED chip (12) facing upward, a plurality of first LED chips (11) and a plurality of second LED chips (12) are arranged at intervals,
wherein in a step of removing the first temporary substrate (21) to obtain the first package (1) containing the first LED chip (11), and removing the second temporary substrate (22) to obtain the second package (2) containing the second LED chip (12), after the first temporary substrate (21) is removed, a plurality of first packages (1) containing the first LED chip (11) are obtained by performing cutting with one first LED chip (11) as a unit, after the second temporary substrate (22) is removed, a plurality of second packages (2) containing the second LED chip (12) are obtained by performing cutting with one second LED chip (12) as a unit.

8. The processing method of the LED display module as claimed in claim 1, wherein in a step of removing the first temporary substrate (21) to obtain the first package (1) containing the first LED chip (11), and removing the second temporary substrate (22) to obtain the second package (2) containing the second LED chip (12), a ratio of a volume of the first package (1) to a volume of the first LED chip (11) ranges from 1.1 to 2, a ratio of a volume of the second package (2) to a volume of the second LED chip (12) ranges from 1.1 to 2.

9. The processing method of the LED display module as claimed in claim 1, wherein
the wavelength of the first LED chip (11) ranges from 440 nm to 460 nm, the wavelength of the second LED chip (12) ranges from 460 nm to 475 nm,
in a step of packaging the bottom and the side of the first LED chip (11) with the first reflective adhesive (31), and packaging the bottom and the side of the second LED chip (12) with the second reflective adhesive (32), a reflectivity of the first reflective adhesive (31) is between 85% and 100%, a reflectivity of the second reflective adhesive (32) is between 85% and 100%.

10. The processing method of the LED display module as claimed in claim 1, wherein in a step of packaging the front surface of the first LED chip (11) with the first isolation layer (41), and packaging the front surface of the second LED chip (12) with the second isolation layer (42), the first isolation layer (41) comprises a first epoxy resin or a first silica gel, the second isolation layer (42) comprises a second epoxy resin or a second silica gel.

## Patentansprüche

1. Verfahren zur Verarbeitung eines LED-Anzeigemoduls, wobei das Verarbeitungsverfahren für das LED-Anzeigemodul die folgenden Schritte umfasst:
Erwerben eines ersten LED-Chips (11), der blaues Licht aussendet, und eines zweiten LED-Chips (12), der blaues Licht aussendet, wobei eine Wellenlänge des ersten LED-Chips (11) kleiner ist als eine Wellenlänge des zweiten LED-Chips (12);
Platzieren des ersten LED-Chips (11) auf einem ersten temporären Substrat (21), wobei eine Vorderseite des ersten LED-Chips (11) nach oben zeigt und Platzieren des zweiten LED-Chips (12) auf einem zweiten temporären Substrat (22), wobei eine Vorderseite des zweiten LED-Chips (12) nach oben zeigt;
Verpacken einer Unterseite und einer Seite des ersten LED-Chips (11) mit einem ersten reflektierenden Kleber (31) und Verpacken einer Unterseite und einer Seite des zweiten LED-Chips (12) mit einem zweiten reflektierenden Klebstoff (32);
Verpacken der Vorderfläche des ersten LED-Chips (11) mit einer ersten Isolationsschicht (41) und Verpacken der Vorderfläche des zweiten LED-Chips (12) mit einer zweiten Isolationsschicht (42);
Entfernen des ersten temporären Substrats (21), um ein erstes Gehäuse (1) zu erhalten, das den ersten LED-Chip (11) enthält, und Entfernen des zweiten temporären Substrats (22), um ein zweites Gehäuse (2) zu erhalten, das den zweiten LED-Chip (12) enthält, wobei eine Höhe des zweiten Gehäuses (2) größer als eine Höhe des ersten Gehäuses (1) ist; und
Befestigen mehrerer Anzeigeeinheiten an einem Substrat (23), wobei jede der mehreren Anzeigeeinheiten zwei erste Gehäuse (1) und ein zweites Gehäuse (2) umfasst; Aufsprühen einer roten Quantenschicht (51) auf eine Vorderfläche eines der beiden ersten Pakete (1), um ein rotes Quantenpaket zu erhalten; Aufsprühen einer grünen Quantenschicht (52) auf eine Vorderfläche des anderen der beiden ersten Pakete (1), um ein grünes Quantenpaket zu erhalten; und eine Vorderfläche des roten Quantenpakets, eine Vorderfläche des grünen Quantenpakets und eine Vorderfläche des zweiten Pakets (2) bündig sind.

2. Verfahren zur Verarbeitung des LED-Anzeigemoduls nach Anspruch 1, wobei nach einem Schritt des Befestigens der mehreren Anzeigeeinheiten am Substrat (23), wobei jede der mehreren Anzeigeeinheiten zwei erste Gehäuse (1) und ein zweites Gehäuse (2) umfasst; Aufsprühen der roten Quantenschicht (51) auf die Vorderfläche eines der beiden ersten Pakete (1), um das rote Quantenpaket zu erhalten; Aufsprühen der grünen Quantenschicht (52) auf die Vorderseite des anderen der beiden ersten Pakete (1), um ein grünes Quantenpaket zu erhalten; und die Vorderfläche des roten Quantenpakets, die Vorderfläche des grünen Quantenpakets und die Vorderfläche des zweiten Pakets (2) bündig sind, wobei das Verarbeitungsverfahren des LED-Anzeigemoduls weiterhin Folgendes umfasst: Füllen eines Bereichs außerhalb des roten Quantenpakets, des grünen Quantenpakets und des zweiten Pakets (2) auf dem Substrat (23) mit einer lichtabsorbierenden Klebeschicht (61), wobei eine Vorderfläche der lichtabsorbierenden Klebeschicht (61) bündig mit der Vorderfläche des roten Quantenpakets, der Vorderfläche des grünen Quantenpakets und der Vorderfläche des zweiten Pakets (2) ist.

3. Verfahren zur Verarbeitung des LED-Anzeigemoduls nach Anspruch 2, wobei nach einem Schritt des Füllens des Bereichs außerhalb des roten Quantenpakets, des grünen Quantenpakets und des zweiten Pakets (2) auf dem Substrat (23) die lichtabsorbierende Klebeschicht (61) aufgetragen wird, die Vorderfläche der lichtabsorbierenden Klebeschicht (61) bündig mit der Vorderfläche des roten Quantenpakets, der Vorderfläche des grünen Quantenpakets und der Vorderfläche des zweiten Pakets (2) abschließt, das Verarbeitungsverfahren des LED-Anzeigemoduls weiterhin Folgendes umfasst: Verpacken eines Anzeigemoduls, das die lichtabsorbierende Klebeschicht (61) enthält, mit einer Schutzschicht (62), wobei eine Lichtdurchlässigkeit der Schutzschicht (62) größer oder gleich 30% ist.

4. Verfahren zur Verarbeitung des LED-Anzeigemoduls nach Anspruch 1, wobei vor einem Schritt des Platzierens des ersten LED-Chips (11) auf dem ersten temporären Substrat (21) mit der Vorderseite des ersten LED-Chips (11) nach oben gerichtet ist und des Platzierens des zweiten LED-Chips (12) auf dem zweiten temporären Substrat (22), wobei die Vorderseite des zweiten LED-Chips (12) nach oben zeigt, das Verarbeitungsverfahren des LED-Anzeigemoduls weiterhin Folgendes umfasst: Beschichten des ersten temporären Substrats (21) mit einem ersten Trennmittel oder einem ersten Trennklebstoff und Beschichten des zweiten temporären Substrats (22) mit einem zweiten Trennmittel oder einem zweiten Trennklebstoff.

5. Verarbeitungsverfahren für das LED-Anzeigemodul nach Anspruch 1, wobei
in einem Schritt des Verpackens der Unterseite und der Seite des ersten LED-Chips (11) mit dem ersten reflektierenden Kleber (31) und des Verpackens der Unterseite und der Seite des zweiten LED-Chips (12) mit dem zweiten reflektierenden Kleber (32):
eine Dicke des ersten reflektierenden Klebers (31), der sich außerhalb der Seite des ersten LED-Chips (11) befindet, größer ist als eine erste Dicke, wobei die erste Dicke eine Summe aus einer Dicke einer Epitaxieschicht des ersten LED-Chips (11) und einer Dicke einer Elektrode des ersten LED-Chips (11) ist,
eine Dicke des zweiten reflektierenden Klebers (32), der sich außerhalb der Seite des zweiten LED-Chips (12) befindet, größer ist als eine zweite Dicke, wobei die zweite Dicke eine Summe aus einer Dicke einer Epitaxieschicht des zweiten LED-Chips (12) und einer Dicke einer Elektrode des zweiten LED-Chips (12) ist.

6. Verfahren zur Verarbeitung des LED-Anzeigemoduls nach Anspruch 5, wobei
die Dicke des ersten reflektierenden Klebers (31), der sich außerhalb der Seite des ersten LED-Chips (11) befindet, kleiner ist als eine Dicke des ersten LED-Chips (11), wobei die Dicke des ersten LED-Chips (11) gleich einer Summe aus der Dicke eines Substrats des ersten LED-Chips (11) und der Dicke der Epitaxieschicht des ersten LED-Chips (11) und der Dicke der Elektrode des ersten LED-Chips (11) ist,
die Dicke des zweiten reflektierenden Klebers (32), der sich außerhalb der Seite des zweiten LED-Chips (12) befindet, kleiner ist als eine Dicke des zweiten LED-Chips (12), wobei die Dicke des zweiten LED-Chips (12) gleich einer Summe aus einer Dicke des Substrats des zweiten LED-Chips (12) und der Dicke der Epitaxieschicht des zweiten LED-Chips (12) und der Dicke der Elektrode des zweiten LED-Chips (12) ist.

7. Verfahren zur Verarbeitung des LED-Anzeigemoduls nach Anspruch 1, wobei
in einem Schritt des Platzierens des ersten LED-Chips (11) auf dem ersten temporären Substrat (21), wobei die Vorderseite des ersten LED-Chips (11) nach oben zeigt, und Platzieren des zweiten LED-Chips (12) auf dem zweiten temporären Substrat (22), wobei die Vorderseite des zweiten LED-Chips (12) nach oben zeigt, mehrere erste LED-Chips (11) und mehrere zweite LED-Chips (12) in Abständen angeordnet sind,
wobei in einem Schritt des Entfernens des ersten temporären Substrats (21) das erste Gehäuse (1) erhalten wird, das den ersten LED-Chip (11) enthält, und des Entfernens des zweiten temporären Substrats (22), um das zweite Gehäuse (2) zu erhalten, das den zweiten LED-Chip (12) enthält nachdem das erste temporäre Substrat (21) entfernt wurde, mehrere erste Pakete (1), die den ersten LED-Chip (11) enthalten, durch Schneiden mit einem ersten LED-Chip (11) als Einheit erhalten werden, nachdem das zweite temporäre Substrat (22) entfernt wurde, mehrere zweite Pakete (2), die den zweiten LED-Chip (12) enthalten, durch Schneiden mit einem zweiten LED-Chip (12) als Einheit erhalten werden.

8. Verfahren zur Verarbeitung des LED-Anzeigemoduls nach Anspruch 1, wobei in einem Schritt des Entfernens des ersten temporären Substrats (21) das erste Gehäuse (1) erhalten wird, das den ersten LED-Chip (11) enthält, und des Entfernens des zweiten temporären Substrats (22), um das zweite Gehäuse (2) zu erhalten, das den zweiten LED-Chip (12) enthält, ein Verhältnis eines Volumens des ersten Gehäuses (1) zu einem Volumen des ersten LED-Chips (11) im Bereich von 1,1 bis 2 liegt, ein Verhältnis eines Volumens des zweiten Gehäuses (2) zu einem Volumen des zweiten LED-Chips (12) im Bereich von 1,1 bis 2 liegt.

9. Verfahren zur Verarbeitung des LED-Anzeigemoduls nach Anspruch 1, wobei
die Wellenlänge des ersten LED-Chips (11) im Bereich von 440 nm bis 460 nm liegt, die Wellenlänge des zweiten LED-Chips (12) im Bereich von 460 nm bis 475 nm liegt,
in einem Schritt des Verpackens der Unterseite und der Seite des ersten LED-Chips (11) mit dem ersten reflektierenden Kleber (31) und des Verpackens der Unterseite und der Seite des zweiten LED-Chips (12) mit dem zweiten reflektierenden Kleber (32), ein Reflexionsgrad des ersten reflektierenden Klebers (31) zwischen 85% und 100% liegt, ein Reflexionsgrad des zweiten reflektierenden Klebers (32) zwischen 85% und 100% liegt.

10. Verfahren zur Verarbeitung des LED-Anzeigemoduls nach Anspruch 1, wobei in einem Schritt des Verpackens der Vorderfläche des ersten LED-Chips (11) mit der ersten Isolationsschicht (41) und des Verpackens der Vorderfläche des zweiten LED-Chips (12) mit der zweiten Isolationsschicht (42), die erste Isolationsschicht (41) ein erstes Epoxidharz oder ein erstes Kieselgel umfasst, die zweite Isolationsschicht (42) ein zweites Epoxidharz oder ein zweites Kieselgel umfasst.

## Revendications

1. Procédé de traitement d'un module d'affichage à DEL, dans lequel le procédé de traitement du module d'affichage à DEL comprend les étapes suivantes :
l'acquisition d'une première puce DEL (11) émettant de la lumière bleue et d'une seconde puce DEL (12) émettant de la lumière bleue, une longueur d'onde de la première puce DEL (11) étant inférieure à une longueur d'onde de la seconde puce DEL (12) ;
le positionnement de la première puce DEL (11) sur un premier substrat temporaire (21) avec une surface avant de la première puce DEL (11) tournée vers le haut, et le positionnement de la seconde puce DEL (12) sur un second substrat temporaire (22) avec une surface avant de la seconde puce DEL (12) tournée vers le haut ;
le conditionnement d'une partie inférieure et d'un côté de la première puce DEL (11) avec un premier adhésif réfléchissant (31), et le conditionnement d'une partie inférieure et d'un côté de la seconde puce DEL (12) avec un second adhésif réfléchissant (32) ;
le conditionnement de la surface avant de la première puce DEL (11) avec une première couche d'isolation (41), et le conditionnement de la surface avant de la seconde puce DEL (12) avec une seconde couche d'isolation (42) ;
le retrait du premier substrat temporaire (21) pour obtenir un premier conditionnement (1) contenant la première puce DEL (11), et le retrait du second substrat temporaire (22) pour obtenir un deuxième conditionnement (2) contenant la seconde puce DEL (12), une hauteur du second conditionnement (2) étant supérieure à une hauteur du premier conditionnement (1) ; et
la fixation d'une pluralité d'unités d'affichage sur un substrat (23), chacune de la pluralité d'unités d'affichage comprenant deux premiers conditionnements (1) et un second conditionnement (2) ; la pulvérisation d'une couche quantique rouge (51) sur une surface avant de l'un des deux premiers conditionnements (1) pour obtenir un conditionnement quantique rouge ; la pulvérisation d'une couche quantique verte (52) sur une surface avant de l'autre des deux premiers conditionnements (1) pour obtenir un conditionnement quantique vert ; et une surface avant du conditionnement quantique rouge, une surface avant du conditionnement quantique vert et une surface avant du second conditionnement (2) étant de niveau.

2. Procédé de traitement du module d'affichage à DEL selon la revendication 1, dans lequel après une étape de fixation de la pluralité d'unités d'affichage au substrat (23), chacune de la pluralité d'unités d'affichage comprenant deux premiers conditionnements (1) et un second conditionnement (2) ; la pulvérisation de la couche quantique rouge (51) sur la surface avant de l'un des deux premiers conditionnements (1) pour obtenir le conditionnement quantique rouge ; la pulvérisation de la couche quantique verte (52) sur la surface avant de l'autre des deux premiers conditionnements (1) pour obtenir un conditionnement quantique vert ; et la surface avant du conditionnement quantique rouge, la surface avant du conditionnement quantique vert et la surface avant du deuxième conditionnement (2) étant de niveau, le procédé de traitement du module d'affichage à DEL comprenant en outre : le remplissage d'une zone à l'extérieur du conditionnement quantique rouge, du conditionnement quantique vert et du second conditionnement (2) sur le substrat (23) avec une couche adhésive absorbant la lumière (61), une surface avant de la couche adhésive absorbant la lumière (61) étant de niveau avec la surface avant du conditionnement quantique rouge, la surface avant du conditionnement quantique vert et la surface avant du second conditionnement (2).

3. Procédé de traitement du module d'affichage à DEL selon la revendication 2, dans lequel après une étape de remplissage de la zone à l'extérieur du conditionnement quantique rouge, du conditionnement quantique vert et du second conditionnement (2) sur le substrat (23) avec la couche adhésive absorbant la lumière (61), la surface avant de la couche adhésive absorbant la lumière (61) étant de niveau avec la surface avant du conditionnement quantique rouge, la surface avant du conditionnement quantique vert et la surface avant du second conditionnement (2), le procédé de traitement du module d'affichage à DEL comprenant en outre : le conditionnement d'un module d'affichage contenant la couche adhésive absorbant la lumière (61) avec une couche protectrice (62), une transmittance lumineuse de la couche protectrice (62) étant supérieure ou égale à 30 %.

4. Procédé de traitement du module d'affichage à DEL selon la revendication 1, dans lequel avant une étape de positionnement de la première puce DEL (11) sur le premier substrat temporaire (21) avec la surface avant de la première puce DEL (11) tournée vers le haut, et le positionnement de la seconde puce DEL (12) sur le second substrat temporaire (22) avec la surface avant de la seconde puce DEL (12) tournée vers le haut, le procédé de traitement du module d'affichage à DEL comprenant en outre : le revêtement du premier substrat temporaire (21) avec un premier agent de démoulage ou un premier adhésif de démoulage, et le revêtement du second substrat temporaire (22) avec un second agent de démoulage ou un second adhésif de démoulage.

5. Procédé de traitement du module d'affichage à DEL selon la revendication 1, dans lequel dans une étape de conditionnement de la partie inférieure et du côté de la première puce DEL (11) avec le premier adhésif réfléchissant (31), et le conditionnement de la partie inférieure et du côté de la seconde puce DEL (12) avec le second adhésif réfléchissant (32) :
une épaisseur du premier adhésif réfléchissant (31) situé à l'extérieur du côté de la première puce DEL (11) est supérieure à une première épaisseur, la première épaisseur étant la somme d'une épaisseur d'une couche épitaxiale de la première puce DEL (11) et une épaisseur d'une électrode de la première puce DEL (11),
une épaisseur du second adhésif réfléchissant (32) situé à l'extérieur du côté de la seconde puce DEL (12) est supérieure à une seconde épaisseur, la seconde épaisseur étant la somme d'une épaisseur d'une couche épitaxiale de la seconde puce DEL (12) et une épaisseur d'une électrode de la seconde puce DEL (12).

6. Procédé de traitement du module d'affichage à DEL selon la revendication 5, dans lequel
l'épaisseur du premier adhésif réfléchissant (31) situé à l'extérieur du côté de la première puce DEL (11) est inférieure à une épaisseur de la première puce DEL (11), l'épaisseur de la première puce DEL (11) étant égale à la somme de l'épaisseur d'un substrat de la première puce DEL (11), de l'épaisseur de la couche épitaxiale de la première puce DEL (11) et de l'épaisseur de l'électrode de la première puce DEL (11),
l'épaisseur du second adhésif réfléchissant (32) situé à l'extérieur du côté de la seconde puce DEL (12) est inférieure à une épaisseur de la seconde puce DEL (12), l'épaisseur de la seconde puce DEL (12) étant égale à la somme d'une épaisseur du substrat de la seconde puce DEL (12), de l'épaisseur de la couche épitaxiale de la seconde puce DEL (12) et de l'épaisseur de l'électrode de la seconde puce DEL (12).

7. Procédé de traitement du module d'affichage à DEL selon la revendication 1, dans lequel
dans une étape de positionnement de la première puce DEL (11) sur le premier substrat temporaire (21) avec la surface avant de la première puce DEL (11) tournée vers le haut, et de positionnement de la seconde puce DEL (12) sur le second substrat temporaire (22) avec la surface avant de la seconde puce DEL (12) tournée vers le haut, une pluralité de premières puces DEL (11) et une pluralité de secondes puces DEL (12) sont disposées à intervalles,
dans lequel, dans une étape de retrait du premier substrat temporaire (21) pour obtenir la première boîte (1) contenant la première puce DEL (11), et de retrait du second substrat temporaire (22) pour obtenir la seconde boîte (2) contenant la seconde puce DEL (12), après le retrait du premier substrat temporaire (21), une pluralité de premières boîtes (1) contenant la première puce DEL (11) sont obtenues en effectuant une découpe avec une première puce DEL (11) en tant qu'unité, après le retrait du second substrat temporaire (22), une pluralité de secondes boîtes (2) contenant la seconde puce DEL (12) sont obtenues en effectuant une découpe avec une seconde puce DEL (12) en tant qu'unité.

8. Procédé de traitement du module d'affichage à DEL selon la revendication 1, dans lequel dans une étape de retrait du premier substrat temporaire (21) pour obtenir le premier conditionnement (1) contenant la première puce DEL (11), et de retrait du second substrat temporaire (22) pour obtenir le second conditionnement (2) contenant la seconde puce DEL (12), un rapport entre le volume du premier conditionnement (1) et le volume de la première puce DEL (11) est compris entre 1,1 et 2, un rapport entre le volume du second conditionnement (2) et le volume de la seconde puce DEL (12) est compris entre 1,1 et 2.

9. Procédé de traitement du module d'affichage à DEL selon la revendication 1, dans lequel la longueur d'onde de la première puce DEL (11) est comprise entre 440 nm et 460 nm, la longueur d'onde de la seconde puce DEL (12) est comprise entre 460 nm et 475 nm, dans une étape de conditionnement de la partie inférieure et du côté de la première puce DEL (11) avec le premier adhésif réfléchissant (31), et de conditionnement de la partie inférieure et du côté de la seconde puce DEL (12) avec le second adhésif réfléchissant (32), une réflectivité du premier adhésif réfléchissant (31) est comprise entre 85 % et 100 %, une réflectivité du second adhésif réfléchissant (32) est comprise entre 85 % et 100 %.

10. Procédé de traitement du module d'affichage à DEL selon la revendication 1, dans lequel dans une étape de conditionnement de la surface avant de la première puce DEL (11) avec la première couche d'isolation (41), et de conditionnement de la surface avant de la seconde puce DEL (12) avec la seconde couche d'isolation (42), la première couche d'isolation (41) comprend une première résine époxy ou un premier gel de silice, la seconde couche d'isolation (42) comprend une seconde résine époxy ou un second gel de silice.
